# EUROPÄISCHE PATENTSCHRIFT

(11) **EP 1 792 665 B1**
(45) Veröffentlichungstag und Bekanntmachung des Hinweises auf die Patenterteilung: **18.03.2009**
(21) Anmeldenummer: 05026473.8
(22) Anmeldetag: 05.12.2005
(51) Int. Cl.: B07C 3/14

(54) **Logistiksystem zum Befördern von Postsendungen und Verfahren zum Festlegen eines Transportwegs**
Logistical system for transportation of mail and method for determination of a transportation path
Système logistique pour le transport de courrier et méthode pour déterminer un chemin de transport

(43) Veröffentlichungstag der Anmeldung: 06.06.2007
(73) Patentinhaber: Deutsche Post AG, 53113 Bonn (DE)
(72) Erfinder: Girnus, Malte, 64293 Darmstadt (DE); Harbaum, Michael, 64295 Darmstadt (DE); Dressler, Michael, 55450 Langenlonsheim (DE)
(74) Vertreter: Jostarndt, Hans-Dieter

(56) Entgegenhaltungen:
- US-A1- 2002 139 727
- US-A1- 2005 071 287
- US-A1- 2005 137 991
- US-B1- 6 459 953

## Beschreibung

Die Erfindung betrifft ein Logistiksystem zum Befördern einer Postsendung auf einem Transportweg innerhalb eines Postverteilnetzes, wobei der Transportweg mehrere Knoten des Postverteilnetzes enthält, insbesondere einen Knoten, der einem Zustellpunkt entspricht, sowie wenigstens einen Knoten, der einem Sortierpunkt entspricht.

Ferner betrifft die Erfindung ein Verfahren zum Festlegen des Transportwegs einer Postsendung innerhalb eines Postverteilnetzes.

Die Beförderung einer Postsendung zu einem Zustellpunkt, wie beispielsweise einer Hausadresse oder einem Postfach, erfolgt üblicherweise auf einem Transportweg, der mehrere Sortierpunkte enthält, an denen die Sendungen auf weitere Knoten eines Postverteilnetzes verteilt werden.

Üblicherweise ist es dabei vorgesehen, dass die Postsendungen, die in einer bestimmten Region abgesandt werden, in einem Verteilzentrum eines Postunternehmens gesammelt werden, wo im Rahmen einer so genannten Abgangssortierung die Verteilung der Postsendungen auf die Zielregionen vorgenommen wird. In dem Verteilzentrum der Zielregion erfolgt dann im Rahmen der so genannten Eingangssortierung eine Feinsortierung, bei der die Postsendungen insbesondere auf die einzelnen Zustellbezirke verteilt werden, in denen sie durch jeweils einen Zusteller zugestellt werden.

Zur Feinsortierung der Sendungen sind Feinsortierprogramme für die Sortiereinrichtungen der Verteilzentren in der Zielregion vorgesehen. Im Rahmen eines Feinsortierprogramms werden dabei Sendungen sortiert, die in bestimmten Zustellbezirken des Versorgungsbereichs des Verteilzentrums zuzustellen sind. Die Feinsortierung wird dabei bereits bei der Abgangssortierung der Postsendungen vorbereitet, indem die Sendungen im Rahmen der Abgangssortierung auf Sortierpunkte verteilt werden, die einem so genannten Feinsortierprogramm der Eingangssortierung zugeordnet sind. Dabei können bei der Eingangssortierung auch mehrere Feinsortierprogramme vorgesehen sein, wobei die Sendungen eines Feinsortierprogramms auf die folgenden Feinsortierprogramme verteilt werden.

Somit werden für die Beförderung der Postsendungen Zustellpunkte zu Zustellbezirken zusammengefasst und Zustellbezirke ihrerseits zu Gruppierungen von Zustellbezirken, die jeweils einem Feinsortierprogramm zugeordnet sind, welches einem bestimmten Verteilzentrum zugeordnet ist.

Der Transportweg der Postsendungen von dem Verteilzentrum der Quellregion zu einem Zustellpunkt enthält somit das Verteilzentrum der Zielregion der Postsendung, den Maschineneingang der für die Feinsortierung vorgesehenen Sortiereinrichtung, gegebenenfalls die Maschineneingänge für weitere Feinsortierprogramme, den Zustellbezirk, dem die Zustelladresse der Postsendung zugeordnet ist sowie den Zustellpunkt, an dem die Postsendung zugestellt wird.

Zur Sortierung werden die Postsendungen nach dem Stand der Technik mit einem Code versehen, in welchem die aufgebrachte Zustelladresse codiert wird. Im Bereich der Anmelderin handelt es sich dabei um einen elfstelligen Code, der die fünfstellige Postleitzahl der Adresse, eine codierte Angabe des Straßenabschnitts der Zustelladresse sowie ein Angabe der Hausnummer enthält. Die Postleitzahl bezeichnet dabei eine bestimmte Zustellbezirksgruppe, welche den Zustellbezirk umfasst, dem die Sendung zugeordnet ist. Die ersten beiden Ziffern geben dabei die Region an, die in der Regel einem Versorgungsbereich eines Verteilzentrums entspricht.

Anhand dieses Sortiercodes, der bereits bestimmte Gruppierungen von Zustellpunkten, wie beispielsweise Zustellbezirksgruppen oder einen Versorgungsbereich eines Verteilzentrums, angibt, erfolgt nach dem Stand der Technik auch die Festlegung des Transportwegs bzw. der in dem Transportweg enthaltenen Knoten des Postverteilnetzes, welche ihrem Sortiercode dabei fest zugeordnet sind.

Hierdurch ist es nur eingeschränkt möglich bzw. sehr aufwändig und unübersichtlich, den Transportweg einer Postsendung zu verändern, da den Zustellpunkten ein fester Sortiercode zugeordnet ist, der bereits die Angabe bestimmter Knoten des Transportwegs, wie etwa des Verteilzentrums für die Eingangssortierung, enthält.

Zudem besteht das Problem, dass die Festlegung der Transportwege von Postsendungen, die üblicherweise innerhalb eines Datenbanksystems erfolgt, sehr unübersichtlich und fehleranfällig wird, wenn die vorgesehenen Knoten des Transportwegs nicht den Angaben innerhalb des Sortiercodes entsprechen, was beispielsweise der Fall ist, wenn die Eingangssortierung einer Postsendung in einem Verteilzentrum durchgeführt werden soll, das einer anderen Region als der in dem Sortiercode angegebenen Zielregion der Sendung zugeordnet ist.

Ferner ist es nicht bzw. nur sehr eingeschränkt möglich, Knoten in das Postverteilnetz zu integrieren, welche nicht anhand des vorgesehenen Sortiercodes beschrieben werden können, wie beispielsweise Knoten des Postverteilnetzes eines anderen Landes oder eines anderen Zustellunternehmens, das andere Sortiercodes nutzt.

Die US-Patentanmeldung US 2005/0071287 A1 beschreibt ein Postverarbeitungssystem mit mehreren Verarbeitungsmaschinen, bei dem für einen Empfänger bestimmte Sendungen in einem Behälter enthalten sind. Die Behälter können verschiedene Wege durch das Verarbeitungssystem nehmen. Die Behälter sind mit einer Kennzeichnung versehen, die Verarbeitungshinweise für den Behälter angibt, insbesondere den Weg des Behälter bei der Verarbeitung.

Es ist eine Aufgabe der vorliegenden Erfindung, eine von dem Sortiercode unabhängige Festlegung des Transportwegs einer Postsendung innerhalb eines Postverteilnetzes zu ermöglichen.

Erfindungsgemäß wird diese Aufgabe durch ein Logistiksystem mit den Merkmalen des Patentanspruchs 1 sowie durch ein Verfahren mit den Merkmalen des Patentanspruchs 21 gelöst.

Demgemäß ist es vorgesehen, dass ein Logistiksystem der eingangs genannten Art so ausgestaltet wird, dass den Knoten innerhalb der Datenbank eine eindeutige Identifikationskennung zugeordnet ist und dass einem ersten Knoten innerhalb der Datenbank die Identifikationskennung eines zweiten Knotens zugeordnet ist, wobei der zweite Knoten dem ersten Knoten auf dem Transportweg der Postsendung vorausgeht oder nachfolgt.

Der Begriff Logistiksystem ist dabei im Rahmen der Erfindung in einer weiten Bedeutung zu verstehen. Er umfasst insbesondere Systeme, welche die erforderlichen Mittel und Einrichtungen enthalten, um den Transport von Postsendungen von einem Abgangsort zu einem Zustellpunkt auf einem Transportweg innerhalb eines Postverteilnetzes durchzuführen.

Das erfindungsgemäße Verfahren zum Festlegen eines Transportwegs einer Postsendung innerhalb eines Postverteilnetzes, wobei der Transportweg mehrere Knoten des Postverteilnetzes enthält, insbesondere einen Knoten, der einem Zustellpunkt entspricht sowie wenigstens einen Knoten, der einem Sortierpunkt entspricht, wobei der Transportweg in einer Datenbank gespeichert wird, zeichnet sich dadurch aus, dass den Knoten innerhalb der Datenbank eine eindeutige Identifikationskennung zugeordnet ist und dass einem ersten Knoten innerhalb der Datenbank die Identifikationskennung eines zweiten Knotens zugeordnet wird, wobei der zweite Knoten dem ersten Knoten auf dem Transportweg der Postsendung vorausgeht oder nachfolgt.

Die Erfindung beinhaltet somit die Idee, jedem Knoten des Postverteilnetzes eine eindeutige Identifikationskennung zuzuordnen und den Transportweg einer Sendung innerhalb des Postverteilnetzes dadurch festzulegen, dass einem Knoten zudem die Identifikationskennung des auf dem Transportweg der Postsendung vorausgehenden Knotens oder des auf dem Transportweg nachfolgenden Knotens zugeordnet wird.

In einer Ausführungsform der Erfindung ergibt sich somit der Transportweg einer Postsendung, die an einen bestimmten Zustellpunkt adressiert ist, ausgehend von dem Knoten, der dem Zustellpunkt entspricht. Anhand der diesem Knoten zugeordneten Angabe der Identifikationskennung des auf dem Transportweg vorausgehenden Knotens wird ermittelt, welches der vorausgehende Knoten ist. Anhand der diesem Knoten zugeordneten Angabe der Identifikationskennung des vorausgehenden Knotens lässt sich dann der diesem Knoten auf dem Transportweg vorausgehende Knoten ermitteln usw.

In einer weiteren Ausführungsform der Erfindung ist einem Knoten die Identifikationskennung des auf dem Transportweg nachfolgenden Knotens zugeordnet, wodurch sich der Transportweg der Postsendung ebenfalls von einem ersten Knoten über weitere Knoten bis hin zu dem Knoten, der dem Zustellpunkt der Postsendung entspricht, ermitteln lässt.

Die Knoten des Logistiknetzes entsprechen dabei im Rahmen der Erfindung insbesondere Zustellpunkten oder Sortierpunkten des Postverteilnetzes. An Sortierpunkten werden Postsendungen, die an bestimmte Zustellpunkte adressiert sind, aus dem Sendungsstrom aussortiert. Von dem Sortierpunkt aus werden die Sendungen an weitere Knoten des Postverteilnetzes weitergeleitet, bei denen es sich beispielsweise um Zustellpunkte oder um weitere Sortierpunkte handelt. Zudem kann ein Knoten des Postverteilnetzes auch einen Bereich, insbesondere einen geographischen Bereich repräsentieren, der bestimmte Zustellpunkte umfasst. Ein Beispiel für einen solchen Knoten ist ein Straßenabschnitt einer Straße eines Ortes, der vorgegebene Hausadressen enthält.

Die nach der Erfindung vorgesehene Festlegung des Transportwegs einer Postsendung ist unabhängig von dem eingangs beschriebenen Sortiercode. Hierdurch ist es in einfacher Weise möglich, Knoten verschiedener Teilbereiche des Postverteilnetzes, in denen unterschiedliche Sortiercodes bzw. Postleitzahlensysteme vorgesehen sind, in dem Transportweg einer Sendung zu berücksichtigen. Ferner weist die Erfindung den Vorteil auf, dass der Transportweg einer Postsendung auf einfache Weise verändert werden kann, indem die einem Knoten zugeordnete Identifikationskennung des auf dem Transportweg vorausgehenden oder nachfolgenden Knotens angepasst wird.

In einer besonders bevorzugten Ausführungsform des erfindungsgemäßen Logistiksystems und des erfindungsgemäßen Verfahrens ist es daher vorgesehen, dass die Zuordnung der Identifikationskennung des zweiten Knotens zu dem ersten Knoten veränderbar ist.

Eine zweckmäßige Ausführungsform des erfindungsgemäßen Logistiksystems und des erfindungsgemäßen Verfahrens sieht vor, dass jedem in dem Transportweg einer Postsendung enthaltenen Knoten bis auf den ersten Knoten des Transportwegs jeweils die Identifikationskennung des auf dem Transportweg vorausgehenden Knotens zugeordnet ist.

Ferner sieht eine zweckmäßige Ausführungsform des erfindungsgemäßen Logistiksystems und des erfindungsgemäßen Verfahrens vor, dass jedem in dem Transportweg einer Postsendung enthaltenen Knoten bis auf den Knoten, der dem Zustellpunkt der Postsendung entspricht, jeweils die Identifikationskennung des auf dem Transportweg nachfolgenden Knotens zugeordnet ist.

Eine weitere besonders bevorzugte Ausführungsform des erfindungsgemäßen Logistiksystems und des erfindungsgemäßen Verfahrens zeichnet sich dadurch aus, dass den Knoten beschreibende Attribute zugeordnet sind.

Hierdurch kann insbesondere einfach ermittelt werden, welchem Zustellpunkt oder Sortierpunkt der Knoten entspricht.

Eine besonders vorteilhafte Weiterbildung des erfindungsgemäßen Logistiksystems und des erfindungsgemäßen Verfahrens sieht vor, dass einem Knoten, der einem Zustellpunkt entspricht, wenigstens ein Sendungsmerkmal zugeordnet ist, das eine an den Zustellpunkt adressierte Postsendung aufweist.

Eine vorteilhafte Ausgestaltung des erfindungsgemäßen Logistiksystems und des erfindungsgemäßen Verfahrens ist dadurch gekennzeichnet, dass einem Knoten, der einem Zustellpunkt entspricht, eine Zustelladresse zugeordnet ist, die auf eine an den Zustellpunkt adressierte Sendung aufzubringen ist.

Auf diese Weise ist es möglich, die Knoten des Postverteilnetzes, die Zustellpunkten zugeordnet sind, in einfacher weise anhand der ihnen zugeordnetn Zustelladresse zu identifizieren.

Die Erfindung ermöglicht es zudem, Zustellpunkten entsprechende Knoten des Postverteilnetzes nicht oder nicht ausschließlich anhand der Zustelladresse zu definieren, sondern weitere Sendungsmerkmale zur Definition von Knoten heranzuziehen, wobei grundsätzlich beliebige, auf irgendeine Weise erfassbare Sendungsmerkmale in Betracht kommen.

Ein Beispiel für ein derartiges Sendungsmerkmal ist eine auf die Postsendung aufgebrachte Angabe eines Zustellunternehmens, welches die Zustellung der Sendung vornimmt.

Eine weitere vorteilhafte Ausgestaltung des erfindungsgemäßen Logistiksystems und des erfindungsgemäßen Verfahrens sieht daher vor, dass einem Knoten ein Zustellunternehmen zugeordnet ist, welches den Transport einer Postsendung zu dem Knoten vornimmt.

In einer zweckmäßigen Ausführungsform des erfindungsgemäßen Logistiksystems und des erfindungsgemäßen Verfahrens ist es insbesondere vorgesehen, dass einem Knoten, der einem Zustellpunkt entspricht, ein Zustellunternehmen zugeordnet ist, das Postsendungen zu diesem Zustellpunkt zustellt.

Dabei ist es insbesondere möglich, für eine Zustelladresse mehrere Zustellpunkten entsprechende Knoten innerhalb des Postverteilnetzes vorzusehen, die jeweils einem bestimmten Zustellunternehmen zugeordnet sind. Hierdurch kann der Transportweg einer Postsendung, die durch ein erstes Zustellunternehmen zugestellt wird, andere dem Zustellpunkt vorausgehende Knoten enthalten als der Transportweg einer Postsendung, die von einem anderen Zustellunternehmen zu derselben Zustelladresse zugestellt wird. Insbesondere können dabei Knoten vorgesehen werden, an denen Postsendungen von dem oder einem weiteren Zustellunternehmen an das zweite Zustellunternehmen übergeben werden.

Darüber hinaus ist es in einer bevorzugten Ausführungsform des erfindungsgemäßen Logistiksystems und des erfindungsgemäßen Verfahrens vorgesehen, dass der Transportweg der Postsendung in einer Datenbank festgelegt ist.

Die Datenbank ist dabei vorzugsweise ein Bestandteil des erfindungsgemäßen Logistiksystems.

Weiterhin ist eine vorteilhafte Ausführungsform des erfindungsgemäßen Logistiksystems und des erfindungsgemäßen Verfahrens dadurch gekennzeichnet, dass in der Datenbank eine Zuordnung zwischen den Knoten des Transportwegs und den eindeutigen Identifikationskennungen gespeichert ist.

Eine zweckmäßige Weiterbildung des erfindungsgemäßen Logistiksystems und des erfindungsgemäßen Verfahrens sieht vor, dass in der Datenbank eine Zuordnung zwischen den Knoten des Transportwegs und ihren Attributen gespeichert ist.

Bei einer zweckmäßigen Weiterbildung des erfindungsgemäßen Logistiksystems und des erfindungsgemäßen Verfahrens ist es ferner vorgesehen, dass in der Datenbank eine Zuordnung zwischen einem ersten Knoten und einem zweiten Knoten gespeichert ist, wobei der zweite Knoten dem ersten Knoten auf dem Transportweg der Postsendung vorausgeht oder nachfolgt.

Darüber hinaus zeichnet sich eine besonders bevorzugte Ausführungsform des erfindungsgemäßen Logistiksystems und des erfindungsgemäßen Verfahrens dadurch aus, dass die Postsendung bei der Sortierung an einem Sortierpunkt aufgrund eines Sortierplans an einen auf dem Transportweg der Postsendung nachfolgenden Knoten weitergeleitet wird.

Eine ebenfalls besonders bevorzugte Ausführungsform des erfindungsgemäßen Logistiksystems und des erfindungsgemäßen Verfahrens sieht vor, dass der Sortierplan anhand der Festlegung von Transportwegen von Postsendungen innerhalb der Datenbank erzeugt wird.

In einer vorteilhaften Ausführungsform des erfindungsgemäßen Logistiksystems und des erfindungsgemäßen Verfahrens ist es vorgesehen, dass die eindeutige Identifikationskennung eines einem Zustellpunkt zugeordneten Knotens auf eine an den Zustellpunkt adressierte Postsendung aufbringbar ist und bei der Sortierung der Postsendung heranziehbar ist.

Eine zweckmäßige Weiterbildung des erfindungsgemäßen Logistiksystems und des erfindungsgemäßen Verfahrens sieht vor, dass Knoten in dem Transportweg von Postsendungen enthalten ist, die an einen Zustellpunkt adressiert sind, der einem Knoten des Postverteilnetzes entspricht, deren Identifikationskennungen dem Knoten, der dem Zustellpunkt entspricht, innerhalb des Sortierplans zugeordnet sind.

In einer gleichfalls vorteilhaften Ausgestaltung des erfindungsgemäßen Logistiksystems und des erfindungsgemäßen Verfahrens ist es vorgesehen, dass den Knoten ein Sortiercode und/oder ein Sortiercodebereich zugeordnet ist.

Eine vorteilhafte Weiterbildung des erfindungsgemäßen Logistiksystems und des erfindungsgemäßen Verfahrens zeichnet sich zudem dadurch aus, dass einem Knoten, der einem Zustellpunkt entspricht, ein Sortiercode zugeordnet ist, welcher auf eine an den Zustellpunkt adressierte Postsendung aufbringbar und bei der Sortierung der Postsendung an einem Sortierpunkt heranziehbar ist.

Eine weitere vorteilhafte Weiterbildung des erfindungsgemäßen Logistiksystems und des erfindungsgemäßen Verfahrens sieht vor, dass die Postsendung von einem ersten Knoten, der einem Sortierpunkt entspricht, an einen auf dem Transportweg nachfolgenden zweiten Knoten weitergeleitet wird, welchem innerhalb des Sortierplans der auf die Postsendung aufgebrachte Sortiercode und/oder ein Sortiercodebereich, der den auf die Postsendung aufgebrachten Sortiercode enthält, zugeordnet ist.

Weitere Vorteile, Besonderheiten und zweckmäßige Weiterbildungen der Erfindung ergeben sich aus den Unteransprüchen und der nachfolgenden Darstellung bevorzugter Ausführungsbeispiele der Erfindung.

Im folgenden wird die Erfindung am Beispiel eines Logistiksystems erläutert, das zur Beförderung von Postsendungen von einem Abgangsort an einen Zielort ausgebildet ist und mehrere von einem Zustellunternehmen betriebene Verteilzentren umfasst, in denen die Abgangssortierung sowie die Eingangssortierung von Postsendungen so vorgenommen wird, wie dies eingangs bereits skizziert worden ist.

Postsendungen, die in einer Region aufgegeben worden sind, werden dabei in dem Verteilzentrum gesammelt, das dieser Region zugeordnet ist. Im Rahmen der Abgangssortierung, die in diesem Verteil zentrum durchgeführt wird, werden die Postsendungen dann auf die Verteilzentren verteilt, die jeweils für die Eingangssortierung der Sendungen vorgesehen sind. Im Rahmen der Eingangssortierung wird dabei eine ein- oder mehrstufige Feinsortierung durchgeführt, um die Postsendungen an die Zusteller oder Empfänger weiterzuverteilen. In jeder Stufe werden die Sendungen dabei im Rahmen eines Feinsortierprogramms sortiert, das die Sortierung von Sendungen umfasst, die an bestimmte Zustellpunkte adressiert sind.

Bei der Abgangssortierung ist es daher vorgesehen, dass die Postsendungen bereits auf die Feinsortierprogramme der ersten Stufe zusortiert werden. Die für die verschiedenen Feinsortierprogramme der Eingangssortierung eines bestimmten Verteilzentrums vorgesehenen Sendungen werden dabei im Rahmen des Abgangssortierprozesses zu einer Kommission zusammengefasst. Die Kommission umfasst dabei mehrere Behälter, die jeweils Postsendungen enthalten, die einem Sortierprogramm der Eingangssortierung zugeführt werden, wobei dieses Sortierprogramm vorzugsweise auf den Behältern vermerkt ist. Nach der Kommissionierung wird die Kommission zu dem Verteilzentrum transportiert, das für die Eingangssortierung der enthaltenen Sendungen zuständig ist. Dieses Verteilzentrum entspricht dabei dem ersten Knoten des Transportwegs der Postsendungen.

Der Teilbereich des Postverteilnetzes, der den Versorgungsbereich eines für die Eingangssortierung vorgesehenen Verteilzentrums umfasst, weist beispielhaft verschiedene Typen von Knoten auf. Üblicherweise besteht eine hierarchische Struktur der Knoten, bei der jedem Knoten einer höheren Hierarchieebene mehrere Knoten einer tieferen Hierarchieebene zugeordnet sind.

Wie zuvor erwähnt, entspricht das Verteilzentrum selbst dabei einem ersten Knoten des Transportwegs von Postsendungen. Dabei werden die Postsendungen, die in dem Verteilzentrum angeliefert werden, zunächst auf die vorgesehenen Feinsortierprogramme der ersten Stufe verteilt. Bei dem Knoten handelt es sich somit um einen Sortierpunkt des Postverteilnetzes.

Bei einer beispielhaften ersten Ausführungsform des Logistiksystems ist es dabei vorgesehen, dass für Postsendungen, die an eine Hausadresse adressiert sind, sowie für Postsendungen, die an einen Großempfänger adressiert sind, mehrere erste Feinsortierprogramme ausgeführt werden, welche Knoten des Postverteilnetzes darstellen, denen die in dem Verteilzentrum angelieferten Postsendungen zunächst zugeführt werden.

Bei einem Großempfänger handelt es sich dabei um einen Empfänger, der regelmäßig eine große Anzahl von Postsendungen empfängt, beispielsweise 200 Sendungen an jedem Werktag. Für einen Großempfänger bestimmte Sendungen werden im Bereich der Anmelderin mit dem Namen des Großempfängers, einem Ort sowie einer Großempfängerpostleitzahl, welche der Großempfänger bei dem Postunternehmen mietet, adressiert. Die Zustellung der Sendungen erfolgt nicht durch einen Zusteller, sondern direkt von dem Verteilzentrum aus.

An den Sortierpunkten, welche Knoten entsprechen, bzw. durch die entsprechenden Feinsortierprogramme werden dabei die Postsendungen für die unterschiedlichen Großempfänger, die von dem Verteilzentrum aus beliefert werden, jeweils zu einer Lieferung zusammengefasst, die nach Abschluss der Sortierung an den entsprechenden Großempfänger geliefert wird. Bei den Großempfängern handelt es sich jeweils um einen Zustellpunkt, der einem Knoten des Postverteilnetzes entspricht.

Für die Postsendungen, die an Hausadressen adressiert sind, ist es vorgesehen, dass anhand der Feinsortierprogramme der ersten Stufe eine Zusortierung auf Feinsortierprogramme der zweiten Stufe erfolgt, die ihrerseits weiteren Sortierpunkten bzw. Knoten des Postverteilnetzes entsprechen. Bei diesen Feinsortierprogrammen kann es sich beispielsweise um Sortierprogramme handeln, welche eine Gangfolgesortierung der Postsendungen durchführen, bei der die Sendungen in einer dem Fachmann bekannten Weise in die Reihenfolge gebracht werden, in der sie von den Zustellern an die Hausadressen zugestellt werden.

Nach der Ausführung dieser Feinsortierprogramme werden die Postsendungen, vorzugsweise nach Zustellbezirken geordnet, in Behälter eingebracht. In dem Verteilzentrum werden die Behälter dann zu Kommissionen zusammengefasst, wobei eine Kommission die Behälter umfasst, welche Postsendungen für die Zustellbezirke enthalten, die einem Zustellstützpunkt zugeordnet sind. Bei einem Zustellstützpunkt handelt es sich um eine Einrichtung innerhalb des Logistiksystems, in der mehrere Zusteller die in ihrem Zustellbezirk auszuliefernden Postsendungen in Empfang nehmen und ihren Zustellgang vorbereiten. Die Zustellstützpunkte entsprechen dabei weiteren Knoten des Postverteilnetzes.

Nach der Kommissionierung der Behälter erfolgt der Transport der verschiedenen Kommissionen von dem Verteilzentrum zu den verschiedenen Zustellstützpunkten. In den Zustellstützpunkten werden die Behälter, die jeweils Postsendungen für einen bestimmten Zustellbezirk enthalten, auf die Zusteller verteilt, welche die Zustellung der Postsendungen zu den Zustellpunkten eines Zustellbezirks vornehmen. Bei einem Zustellstützpunkt handelt es sich somit ebenfalls um einen Sortierpunkt.

Es kann hier auch vorgesehen sein, dass sich die Versorgungsbereiche verschiedener Verteilzentren überschneiden und einem Zustellstützpunkt Postsendungen zugeführt werden, deren Eingangssortierung in unterschiedlichen Verteilzentren vorgenommen wird. So kann beispielsweise die Eingangssortierung von Postsendungen für einen ersten Zustellbezirk, der dem Zustellstützpunkt aufgrund seiner geografischen Nähe zu dem Zustellstützpunkt zugeordnet ist, in einem anderen Verteilzentrum vorgenommen werden als die Eingangssortierung von Postsendungen weiterer Zustellbezirke, die dem Zustellstützpunkt zugeordnet sind.

Die Zustellbezirke bzw. die Zusteller (genauer gesagt, die Taschen, in welche die Zusteller die von ihnen zuzustellenden Postsendungen für den Transport einbringen) entsprechen dabei weiteren Knoten des Postverteilnetzes, bei dem es sich im Prinzip ebenfalls um einen Sortierpunkt handelt, da die Zusteller die Sendungen auf die Hausadressen verteilen (bzw. die in den Taschen vorhandenen Sendungen auf die Hausadressen verteilt werden).

Die Zustellbezirke umfassen mehrere Straßenabschnitte des Straßennetzes eines oder mehrerer Orte und entsprechen weiteren Knoten des Postverteilnetzes. Die Straßenabschnitte umfassen ihrerseits vorgegebene Hausadressen, an die Postsendungen zugestellt werden. Die Hausadressen entsprechen somit Zustellpunkten, die Knoten des Postverteilnetzes darstellen.

Die Festlegung der Beziehungen zwischen den Knoten des Postverteilzentrums, d.h. insbesondere die Zuordnung von Knoten einer tieferen Hierarchieebene zu einer höheren Hierarchieebene, wie beispielsweise die Zuordnung von Hausadressen zu einem Straßenabschnitt oder die Zuordnung von Straßenabschnitten zu einem Zustellbezirk, erfolgt innerhalb des Logistiksystems in einem Datenbanksystem und wird in einer Datenbank gespeichert, deren Datenbestand insbesondere zur Erstellung von Sortierplänen herangezogen wird, die für die Sortierung der Postsendungen anhand der Feinsortierprogramme und für die im Rahmen der Abgangssortierung ausgeführten Sortierprogramme maßgeblich sind.

Im Rahmen der Erfindung ist es dabei vorgesehen, dass für jeden Knoten innerhalb des Postverteilnetzes ein Datenobjekt in der zuvor genannten Datenbank gespeichert ist. Ferner wird jedem Knoten eine eindeutige Identifikationskennung zugeordnet, die ihn innerhalb des gesamten Postverteilnetzes bzw. innerhalb des gesamten Logistiksystems eindeutig kennzeichnet.

Bei der Identifikationskennung handelt es sich in einer bevorzugten Ausführungsform der Erfindung um einen so genannten UUID (Universally Unique Identifier) bzw. einen GUID (Globally Unique Identifier), bei denen die Eindeutigkeit der Kennzeichnung eines Knotens zumindest über einen sehr langen Zeitraum gewährleistet ist. Derartige Identifikationskennungen sind dem Fachmann grundsätzlich bekannt, und Funktionalitäten zu ihrer Erzeugung sind bereits in herkömmlichen Datenbanksystemen, wie beispielsweise dem bekannten Datenbanksystem der Firma ORACLE, enthalten. Beispielsweise ist die Identifikationskennung dabei als ein Code mit 16 Byte (32 Zeichen) ausgebildet, der sich aus einer Kennung des erzeugenden Datenbanksystems und einer Kennung des erzeugenden Datenbankprozesses zusammensetzt.

Die einem Knoten des Postverteilnetzes zugeordnete Identifikationskennung, die im Folgenden auch als RIO-ID bezeichnet wird, wird vorzugsweise in dem Datenobjekt gespeichert, das dem Knoten innerhalb der Datenbank zugeordnet ist. Darüber hinaus enthält das Datenobjekt beschreibende Attribute des Knotens.

Datenobjekte, die einem Zustellpunkt zugeordnet sind, enthalten dabei insbesondere Attribute, die Sendungsmerkmalen einer Postsendung, wie beispielsweise der auf die Postsendung aufgebrachten Zustelladresse, entsprechen, welche die Postsendungen aufweisen bzw. aufweisen müssen, die an die Zustellpunkte adressiert sind.

Die einer Hausdresse zugeordneten Attribute sind dabei insbesondere der Name des zugehörigen Ortes und der zugehörigen Straße, die zugehörige Hausnummer sowie die Postleitzahl, der die Hausadresse zugeordnet ist. Einem Großempfänger werden als Attribute insbesondere der Name des Großempfängers, also beispielsweise der Name des als Großempfänger auftretenden Unternehmens, die Großempfängerpostleitzahl sowie die geografische Adresse des Großempfängers zugeordnet, die den Namen eines Ortes und einer Straße, eine Hausnummer und eine Postleitzahl umfasst.

Einem Straßenabschnitt sind als beschreibende Attribute insbesondere der Name des Ortes und der Straße zugeordnet, in dem sich der Straßenabschnitt befindet. Beschreibende Attribute eines Zustellbezirks und eines Zustellstützpunktes sind beispielsweise der Name des Ortes, in dem sich der Zustellbezirk bzw. der Zustellstützpunkt befindet, sowie eine den Zustellbezirk und den Zustellstützpunkt beschreibende Kennung. Die Kennungen des Zustellstützpunktes und des Zustellbezirks können dabei beispielsweise nach der Durchführung der Eingangssortierung auf die Behälter aufgebracht werden, die nach der Durchführung der Eingangssortierung zu einem bestimmten Zustellstützpunkt transportiert werden und Postsendungen für einen bestimmten dem Zustellstützpunkt zugeordneten Zustellbezirk enthalten. Die Kennungen erlauben dabei insbesondere die manuelle Kommissionierung der Behälter in dem Verteilzentrum, in dem die Abgangssortierung durchgeführt wird, sowie die manuelle Verteilung der Behälter auf die Zustellbezirke in den Zustellstützpunkten.

Einem Verteilzentrum kann ebenfalls der Name des Ortes, in dem es sich befindet sowie eine das Verteilzentrum beschreibende Kennung zugeordnet werden. Einem Sortierprogramm ist als Attribut vorzugsweise eine Angabe des Sortierplans zugeordnet, der ihm zugrunde liegt sowie eine Bezeichnung des Sortierprogramms und eine Kennung der Sortiereinrichtung, in der das Sortierprogramm ausgeführt wird. Die Kennung des Sortierprogramms und/oder die Kennungen der Sortiermaschine, die das Sortierprogramm ausführt sowie die Kennung des Verteilzentrums, in dem sich die Sortiereinrichtung befindet, können dabei beispielsweise auf die Behälter aufgebracht werden, die nach der Abgangssortierung in einem Verteilzentrum kommissioniert und dann zu dem Verteilzentrum transportiert werden, in dem die Eingangsortierung vorgenommen wird.

Darüber hinaus können den Knoten des Postverteilnetzes auch weitere Attribute zugeordnet werden. Einem Zustellpunkt können dabei beispielsweise grundsätzlich alle Merkmale einer an den Zustellpunkt adressierten Postsendung zugeordnet werden, die in irgendeiner Weise erfassbar sind.

Falls die Sendungen innerhalb des Logistiksystems von verschiedenen Zustellunternehmen an eine Hausadresse zugestellt werden, können für die Hausadresse insbesondere zwei Knoten innerhalb des Postverteilnetzes vorgesehen werden, die jeweils einem Zusteller zugeordnet sind. Als Attribute können diesen Knoten die auf den Postsendungen vorhandenen Angaben des für die Zustellung vorgesehenen Zustellunternehmens zugeordnet werden. Die anhand der Zustelladresse und der Angabe des Zustellunternehmens an einen der beiden Knoten adressierten Sendungen können dabei beispielsweise im Rahmen der Eingangssortierung in einem Verteilzentrum auf die Zustellstützpunkte der beiden Zustellunternehmen verteilt werden, die dann den weiteren Transport der Postsendung zu der Hausadresse in der bereits dargestellten Weise oder in anderer Weise vornehmen.

In einer weiteren beispielhaften Ausgestaltung der Erfindung kann es vorgesehen sein, dass für an eine Hausadresse adressierte Eilsendungen ein anderer Transportweg vorgesehen ist als für die übrigen an diese Hausadresse adressierten Postsendungen. In diesem Fall werden im Rahmen der Erfindung ebenfalls zwei Knoten innerhalb des Postverteilnetzes für die Hausadresse vorgesehen, denen jeweils entsprechende Attribute zugeordnet sind.

Neben den zuvor beispielhaft dargestellten beschreibenden Attributen enthalten die einem Knoten zugeordneten Datenobjekte in einer bevorzugten ersten Ausführungsform der Erfindung zudem die RIO-ID des Knotens, welcher auf dem Transportweg der Postsendungen unmittelbar vorausgeht. Ausgehend von einem Zustellpunkt enthalten die den Knoten zugeordneten Datenobjekte dabei somit Verweise auf den unmittelbar auf dem Transportweg vorangehenden Knoten. Das dem ersten Knoten des Transportwegs zugeordnete Datenobjekt enthält keinen Verweis auf einen vorausgehenden Knoten. Der erste Knoten des Transportwegs einer Postsendung entspricht dabei in der Regel dem Verteilzentrum, in dem die Eingangssortierung der Postsendung durchgeführt wird bzw. dem in der ersten Stufe der Eingangssortierung vorgesehenen Feinsortierprogramm.

Dies bedeutet, dass in jedem Datenobjekt, das einem Knoten in einer bestimmten Hierarchieebene zugeordnet ist, die RIO-ID enthalten ist, die dem zugehörigen Knoten in der nächsthöheren Hierarchieebene zugeordnet ist. Insbesondere ist bei der ersten Ausführungsform in einem Datenobjekt, das einer Hausadresse zugeordnet ist, die RIO-ID des Straßenabschnitts enthalten, dem die Hausadresse zugeordnet ist. Das einem Straßenabschnitt zugeordnete Datenobjekt enthält die RIO-ID des Zustellbezirks, dem der Straßenabschnitt zugeordnet ist usw.

Falls es vorgesehen ist, dass einem Zustellstützpunkt Postsendungen von zwei verschiedenen verteilzentren aus zugeführt werden, müssen dabei in dieser Ausführungsform der Erfindung innerhalb des Postverteilnetzes zwei Knoten für diesen Zustellstützpunkt vorgesehen werden, von denen der erste in dem Transportweg der Sendungen enthalten ist, deren Eingangssortierung in einem ersten Verteilzentrum vorgenommen wird und der zweite in dem Transportweg von Sendungen enthalten ist, deren Eingangssortierung in dem zweiten Verteilzentrum vorgenommen wird.

Anhand der Zuordnungen zwischen Knoten des Postverteilnetzes und den auf den Transportwegen von Postsendungen vorausgehenden Knoten sind die Transportwege von Postsendungen, die an bestimmte Zustellpunkte adressiert sind, eindeutig festgelegt. Sie können bestimmt werden, indem ausgehend von dem Zustellpunkt sukzessive die vorangehenden Knoten bestimmt werden.

Der Transportweg für eine Postsendung, die an eine Hausadresse adressiert ist, ergibt sich dabei bei der ersten Ausgestaltung des Logistiksystems beispielsweise, indem für die Hausadresse zunächst der Straßenabschnitt ermittelt wird, der die Hausadresse enthält. Für den Straßenabschnitt wird dann der Zustellbezirk ermittelt, dem der Straßenabschnitt zugeordnet ist, für den Zustellbezirk wird der Zustellstützpunkt ermittelt, dem der Zustellbezirk zugeordnet ist usw.

Eine veränderung des Transportwegs ist bei dieser Ausführungsform der Erfindung in einfacher Weise möglich, indem einem bestimmten Knoten, dem ein anderer als der aktuell vorgesehene Vorgängerknoten auf dem Transportweg der Postsendungen vorausgehen soll, anstelle der aktuell zugeordneten Identifikationskennung die Identifikationskennung des neuen Vorgängerknotens zugeordnet wird. Ist es dabei vorgesehen, dass ein Straßenabschnitt einem anderen Zustellbezirk zugeordnet werden soll, so wird in dem Datenobjekt, das dem Straßenabschnitt zugeordnet ist, die Identifikationsnummer des neuen Zustellbezirks anstelle der Identifikationsnummer des bisherigen Zustellbezirks zugeordnet.

In einer ebenfalls vorteilhaften zweiten Ausführungsform der Erfindung ist vorgesehen, dass die Datenobjekte, die Knoten des Postverteilnetzes zugeordnet sind, anstelle der Angabe der RIO-ID des vorausgehenden Knotens eine Angabe der RIO-ID des auf einem Transportweg der Postsendung nachfolgenden Knotens enthalten. Das Datenobjekt des ersten Knotens des Transportwegs einer einzelnen Postsendung enthält somit die RIO-ID des zweiten Knotens des Transportwegs, das diesem Knoten zugeordnete Datenobjekt enthält die RIO-ID des dritten Knotens usw. Das Datenobjekt, das dem Knoten zugeordnet ist, der dem Zustellpunkt der Sendung auf dem Transportweg vorausgeht, enthält schließlich die Identifikationskennung des Zustellpunktes. Das dem Zustellpunkt zugeordnete Datenobjekt enthält bei dieser Ausführungsform der Erfindung keinen Verweis auf einen weiteren Knoten.

Da auf diese weise die Transportwege von Sendungen zu allen Zustellpunkten des Postverteilnetzes, die denselben ersten Knoten enthalten, festgelegt werden, enthält das Datenobjekt, das einem bestimmten Knoten zugeordnet ist, somit die Identifikationscodes aller Knoten, die auf dem Transportweg wenigstens einer Postsendung nachfolgen. Ausgehend von dem ersten Knoten auf diesen Transportwegen können hierdurch alle den ersten Knoten enthaltenden Transportwege von Postsendungen festgelegt werden.

Um bei dieser Ausführungsform der Erfindung einen einzelnen Transportweg für Sendungen, die an einen bestimmten Zustellpunkt adressiert sind, zu ermitteln, ist es erforderlich, zunächst alle Datenobjekte, die möglichen dem Zustellpunkt vorausgehenden Knoten zugeordnet sind, daraufhin zu überprüfen, ob sie die RIO-ID des Zustellpunktes enthalten. Nach der Bestimmung das Datenobjekts, das die RIO-ID des vorausgehenden Knotens enthält, werden alle Datenobjekte, die diesem Knoten möglicherweise vorausgehenden Knoten zugeordnet sind, daraufhin überprüft, ob sie die RIO-ID dieses Knotens enthalten usw. Dabei ist es besonders zweckmäßig, jedem Knoten eine Typangabe zuzuordnen, die es erlaubt, die möglichen vorausgehenden Knoten zu bestimmen.

Im Hinblick auf die erste Ausführungsform eines Postverteilnetzes bedeutet dies, dass zur Ermittlung des Transportwegs von Postsendungen, die an einen bestimmten Zustellpunkt adressiert sind, zunächst alle Datenobjekte, die Knoten des Typs Straßenabschnitt zugeordnet sind, daraufhin überprüft werden, ob sie die RIO-ID des Zustellpunktes enthalten. Ist dabei der Straßenabschnitt ermittelt worden, dem der Zustellpunkt zugeordnet ist, werden alle Datenobjekte, die Knoten des Typs Zustellbezirk zugeordnet sind, daraufhin überprüft, ob sie die RIO-ID des ermittelten Straßenabschnitts enthalten usw.

Falls einem bestimmten Zustellstützpunkt Postsendungen zugeführt werden, deren Eingangssortierung in verschiedenen Verteilzentren vorgenommen wird, so ist es in dieser Ausführungsform der Erfindung nicht erforderlich, mehrere Knoten für den Zustellstützpunkt innerhalb des Postverteilnetzes vorzusehen.

Eine Veränderung der Transportwege der Postsendungen kann auch in dieser Ausführungsform der Erfindung besonders einfach vorgenommen werden, indem die Zuordnungen zwischen den Knoten angepasst werden. Soll dabei für einen bestimmten Knoten ein anderer Vorgängerknoten als der aktuell vorgesehene festgelegt werden, so wird in dem Datenobjekt, das dem aktuellen Vorgängerknoten zugeordnet ist, die RIO-ID des Knotens gelöscht und in dem Datenobjekt, das dem neuen Vorgängerknoten zugeordnet ist, wird die RIO-ID des Knotens gespeichert.

Soll beispielsweise ein Straßenabschnitt einem zweiten Zustellbezirk anstelle eines ersten zugeordnet werden, so wird die RIO-ID des Straßenabschnitts in dem Datenobjekt, das dem ersten Zustellbezirk zugeordnet ist, gelöscht und in dem Datenobjekt gespeichert, das dem zweiten Zustellbezirk zugeordnet ist.

Die Speicherung der den Knoten des Postverteilnetzes zugeordneten Datenobjekte sowie die Festlegung der Transportwege von Postsendungen in der Datenbank erfolgt im Rahmen der Erfindung vorzugsweise anhand mehrerer Tabellen, die im Folgenden beschrieben werden. Dabei wird beispielhaft von der Ausführungsform der Erfindung ausgegangen, bei der es vorgesehen ist, dass der Transportweg einer Postsendung dadurch festgelegt wird, dass das Datenobjekt eines Knotens des Transportwegs die RIO-ID des auf dem Transportweg vorausgehenden Knotens enthält.

In einer ersten Tabelle mit der Bezeichnung KNOTENTYP werden dabei die bestehenden Typen von Knoten definiert. Diese Tabelle enthält die folgenden Spalten:
- KNOTENTYP_ID, in der Knotentypen zugeordnete Identifikationsnummern gespeichert sind
- NAME, in der die Bezeichnungen der Typen, wie beispielsweise "Straßenabschnitt", angegeben sind
- EBENE, in der angegeben wird, welcher Hierarchieebene die Knoten der verschiedenen Typen zugeordnet sind (hier kann beispielsweise den Knoten vom Typ Verteilzentrum die Ebene 1 und Knoten, die Feinsortierprogrammen der ersten Stufe entsprechen, die Ebene 2 zugeordnet werden)

Ferner liegt eine Tabelle mit der Bezeichnung ZIELTYP_LINK vor, in der die Hierarchie der Knotentypen angegeben wird und - die folgende Spalten enthält:
- KNOTENTYP_LINK_ID, in der Identifikationsnummern der in den Zeilen angegebenen Beziehungen zwischen zwei Knotentypen gespeichert sind
- KNOTENTYP_ID_A, in der die in der Tabelle ZIELTYP angegebenen Identifikationsnummern der übergeordneten Knotentypen eines Knotentyppaares angegeben sind
- KNOTENTYP_ID_B, in der die in der Tabelle ZIELTYP angegebenen Identifikationsnummern der untergeordneten Knotentypen des Knotentyppaares angegeben sind

Zur Speicherung der einzelnen Knoten des Postverteilnetzes und deren Zuordnung zueinander werden drei so genannte Setup-Tabellen verwendet.

Eine erste Setup-Tabelle mit der Bezeichnung TYPE definiert die möglichen Formate der Datenbankeinträge bzw. Attribute der Datenobjekte. Dabei können beispielsweise die Formate NUMBER für Zahlen oder VARCHAR2 für Zeichenketten einer variablen Länge vorgesehen sein. Die Tabelle enthält folgende Spalten:
- TYPE_ID, in der Identifikationsnummern der Formate gespeichert sind
- NAME, in der die Bezeichnungen der Formate angegeben sind

In einer zweiten Setup-Tabelle mit der Bezeichnung KEY wird die Art möglicher Einträge bzw. der Attribute der Datenobjekte definiert. Die Art eines Attributs gibt dabei beispielsweise an, ob es sich um einen Namen, eine Postleitzahl oder eine Hausnummer handelt. Die Tabelle KEY enthält dabei folgende Spalten:
- KEY_ID, in der die Identifikationsnummern der Arten der Attribute gespeichert sind
- NAME, in der die Bezeichnung der Arten der Attribute angegeben werden
- KURZ_NAME, in der Abkürzungen der Arten der Attribute gespeichert werden (z.B. PLZ für Postleitzahl)

In einer weiteren Setup-Tabelle mit der Bezeichnung KEY_KNOTENTYP wird festgelegt, welchen Attribute Knoten eines bestimmten Knotentyps zugeordnet werden können. Die Tabelle enthält folgende Spalten:
- KEY_KNOTENTYP_ID, in der Identifikationsnummern der in den Zeilen angegebenen Zuordnungen eines Attributs zu einem Knotentyp gespeichert sind
- KEY_ID, in der die Identifikationsnummern der Attribute gespeichert werden, die diesen in der Tabelle KEY zugeordnet sind
- KNOTENTYP_ID, in der die Identifikationsnummern der den Attributen zugeordneten Knotentypen gespeichert werden, wobei die Identifikationsnummern den Knotentypen in der Tabelle KNOTENTYP zugeordnet werden

Die den einzelnen Knoten zugeordneten Daten werden anhand von zwei Tabellen mit der Bezeichnung KNOTEN und KEY_VALUE_TYPE gespeichert, die Tabelle KNOTEN enthält dabei vorzugsweise folgende Spalten:
- KNOTEN_ID, in der Identifikationsnummern der Knoten gespeichert sind
- KNOTENTYP_ID, in der die Knotentypen der Knoten angegeben werden
- RIO_ID, in der die RIO-IDs der Knoten angegeben werden
- RIO_ID_MASTER, in der die RIO-IDs der auf dem Transportweg einer Postsendung vorausgehenden Knoten angegeben werden

Die Tabelle KEY_VALUE-TYPE gibt die Attribute der Knoten an und enthält folgende Spalten:
- KEY_VALUE_TYPE_ID, in der Identifikationsnummern der in den Zeilen angegebenen Zuordnungen gespeichert sind
- TYPE_ID, in der die Identifikationsnummern der Formate der in den Zeilen angegebenen Attribute bestimmt werden, wobei die Identifikationsnummern den Formaten in der Tabelle TYPE zugeordnet sind
- KEY_KNOTENTYP_ID, in der die Identifikationsnummern der in der Tabelle KEY_KNOTENTYP angegebenen Zuordnungen zwischen den Knotentypen und den möglichen Attributen gespeichert sind (aus den Einträgen in dieser Spalte geht somit hervor, dass ein bestimmtes Attribut eines bestimmten Knotentyps, wie beispielsweise der Name der Straße, der ein Straßenabschnitt zugeordnet ist, oder der Name eines Großempfängers angegeben wird)
- VALUE, in der die Werte der Attribute angegeben werden (beispielsweise der Wert 50 für eine Hausnummer eines Straßenabschnitts oder der Wert Gartenstraße für den Namen einer Straße, der ein Straßenabschnitt zugeordnet ist)
- KNOTEN_ID, in der die Identifikationsnummern der Knoten angegeben werden, die diesen in der Tabelle KNOTEN zugeordnet sind

Ein Datenobjekt, das einem Knoten eines Verteilobjekts zugeordnet ist, umfasst somit die diesem Knoten zugeordnete Zeile in der Tabelle KNOTEN sowie die Zeilen in der Tabelle KEY_VALUE_TYPE, die diesem Knoten zugeordnet sind.

In den Zeilen der Tabelle KEY_VALUE_TYPE, die einem bestimmten Knoten zugeordnet sind, werden dabei die Zuordnungen zwischen den Attributen, die der Knoten besitzt, und deren Werten angegeben. Die Attribute eines Knotens werden somit vorteilhaft als so genannte Key-Value-Paare gespeichert.

Gegenüber der ebenfalls denkbaren Speicherung der Attribute innerhalb einer Tabelle, in der für jedes mögliche Attribut eines Knotens eine Spalte vorgesehen ist, hat dies den Vorteil, dass die Entstehung unvollständig belegter Datensätze vermieden wird. Beispielsweise müsste dabei in einer derartigen Tabelle eine Spalte vorgesehen sein, in welcher der Name eines Großempfängers angegeben ist. In dieser Spalte würden jedoch lediglich die einem Großempfänger entsprechenden Knoten einen Eintrag besitzen. Bei allen anderen Knotentypen würden die Felder dieser Spalte hingegen unbelegt bleiben.

Die dargestellte Datenbank bzw. die in der Datenbank enthaltene Festlegung der Transportwege der Postsendungen können insbesondere auch zur Erstellung der Sortierpläne herangezogen werden, nach deren Maßgabe die Sortierung an den Sortierknoten erfolgt, wobei für jeden Sortierknoten des Postverteilnetzes vorzugsweise ein Sortierplan erstellt wird.

Der Sortierplan liegt dabei den Sortierprogrammen der Abgangssortierung und den Feinsortierprogrammen der Eingangssortierung zugrunde, die in den Sortiereinrichtungen der Verteilzentren ausgeführt werden. Anhand der Sortierpläne wird dabei festgelegt, welche Postsendungen im Rahmen eines Sortierprogramms in welches Sortierfach der mehrere Sortierfächer aufweisenden Sortiereinrichtung ausgeschleust werden. Jedem Sortierfach ist dabei ein Knoten des Postverteilnetzes zugeordnet, an den die Sendungen weitergeleitet werden, die in das Fach ausgeschleust werden.

Innerhalb der Sortiereinrichtungen erfolgt die Sortierung dabei üblicherweise in Abhängigkeit von einem auf die Postsendungen aufgebrachten Code. Dieser Code wird in der Sortiereinrichtung eingelesen und eine Postsendung anhand des eingelesenen Codes in ein Sortierfach ausgeschleust.

Bei einer vorteilhaften Ausführungsform der Erfindung ist es dabei vorgesehen, dass den Postsendungen, die an einen bestimmten in der zuvor dargestellten Weise durch Attribute beschriebenen Zustellpunkt adressiert sind, die RIO-ID dieses Zustellpunktes zugeordnet wird, bevor die Sendungen in die Sortiereinrichtung eingegeben werden. Um diese Zuordnung vornehmen zu können, werden dabei die den Attributen entsprechenden Sendungsmerkmale erfasst. Die anhand dieser Sendungsmerkmale bzw. Attribute ermittelte RIO-ID kann dann beispielsweise als Barcode auf die Sendungen aufgebracht werden.

Innerhalb der Sortierpläne sind dabei Zuordnungen von RIO-IDs zu Sortierfächern angegeben, so dass eine Postsendung in Abhängigkeit von der aufgebrachten RIO-ID innerhalb der Sortiereinrichtung in ein Sortierfach ausgeschleust werden kann. Insbesondere sind dabei einem Sortierfach, das einem bestimmten Knoten des Postverteilnetzes zugeordnet ist, die RIO-IDs zugeordnet, die Postsendungen zugeordnet werden können, deren Transportweg diesen Knoten enthält. Ist es dabei beispielsweise vorgesehen, dass im Rahmen eines Feinsortierprogramms der Eingangssortierung alle Postsendungen für einen Zustellbezirk in ein bestimmtes Sortierfach ausgeschleust werden sollen, so werden diesem Sortierfach innerhalb des Sortierplans die RIO-IDs aller in dem Zustellbezirk enthaltenen Zustellpunkte zugeordnet.

In einer weiteren Ausgestaltung der Erfindung kann es auch vorgesehen sein, dass den Zustellpunkten zusätzlich Sortiercodes zugeordnet werden und dass die Sortierpläne Zuordnungen zwischen Sortiercodes oder Sortiercodebereichen und Sortierfächern enthalten. Grundsätzlich kann es sich dabei auch um die eingangs dargestellten Sortiercodes nach dem Stand der Technik handeln, wobei auch in diesem Fall der erfindungsgemäße Vorteil besteht, dass die Knoten des Postverteilnetzes und damit die Transportwege von Postsendungen unabhängig von dem Sortiercode und in übersichtlicher Weise festgelegt werden können.

Die Sortiercodes können dabei insbesondere als beliebige, Zustellpunkte identifizierende Codes aufgefasst werden. Gewissermaßen verlieren die einzelnen Stellen des Codes somit im Rahmen der Erfindung ihre Bedeutung im Hinblick auf die Festlegung von Transportwegen. So kann beispielsweise einer Postsendung, die an einen Zustellpunkt adressiert ist, dem ein bestimmter Sortiercode zugeordnet ist, dessen erste Stellen eine bestimmte Region bezeichnen, im Rahmen der Erfindung in einfacher nachvollziehbarer Weise für ihre Eingangssortierung ein Verteilzentrum einer anderen Region zugeordnet werden.

## Patentansprüche

1. Logistiksystem zum Befördern einer Postsendung auf einem Transportweg innerhalb eines Postverteilnetzes, wobei der Transportweg mehrere Knoten des Postverteilnetzes enthält, insbesondere einen Knoten, der einem Zustellpunkt entspricht, sowie wenigstens einen Knoten, der einem Sortierpunkt entspricht,
**dadurch gekennzeichnet,**
**dass** den Knoten eine eindeutige Identifikationskennung (RIO-ID) zugeordnet ist und dass einem ersten Knoten die Identifikationskennung (RIO-ID) eines zweiten Knotens zugeordnet ist, wobei der zweite Knoten dem ersten Knoten auf dem Transportweg der Postsendung vorausgeht oder nachfolgt.

2. Logistiksystem nach Anspruch 1,
**dadurch gekennzeichnet,**
**dass** die Zuordnung der Identifikationskennung (RIO-ID) des zweiten Knotens zu dem ersten Knoten veränderbar ist.

3. Logistiksystem nach Anspruch 1 oder 2,
**dadurch gekennzeichnet,**
**dass** jedem in dem Transportweg einer Postsendung enthaltenen Knoten bis auf den ersten Knoten des Transportwegs jeweils die Identifikationskennung (RIO-ID) des auf dem Transportweg vorausgehenden Knotens zugeordnet ist.

4. Logistiksystem nach Anspruch 1 oder 2,
**dadurch gekennzeichnet,**
**dass** jedem in dem Transportweg einer Postsendung enthaltenen Knoten bis auf den Knoten, der dem Zustellpunkt der Postsendung entspricht, jeweils die Identifikationskennung (RIO-ID) des auf dem Transportweg nachfolgenden Knotens zugeordnet ist.

5. Logistiksystem nach einem der vorangegangenen Ansprüche,
**dadurch gekennzeichnet,**
**dass** den Knoten beschreibende Attribute zugeordnet sind.

6. Logistiksystem nach einem der vorangegangenen Ansprüche,
**dadurch gekennzeichnet,**
**dass** einem Knoten, der einem Zustellpunkt zugeordnet ist, wenigstens ein Sendungsmerkmal zugeordnet ist, das eine an den Zustellpunkt adressierte Postsendung aufweist.

7. Logistiksystem nach einem der vorangegangenen Ansprüche,
**dadurch gekennzeichnet,**
**dass** einem Knoten, der einem Zustellpunkt entspricht, eine Zustelladresse zugeordnet ist, welche auf eine an den Zustellpunkt adressierte Sendung aufzubringen ist.

8. Logistiksystem nach einem der vorangegangenen Ansprüche,
**dadurch gekennzeichnet,**
**dass** einem Knoten ein Zustellunternehmen zugeordnet ist, welches den Transport einer Postsendung zu dem Knoten vornimmt.

9. Logistiksystem nach einem der vorangegangenen Ansprüche,
**dadurch gekennzeichnet,**
**dass** einem Knoten, der einem Zustellpunkt entspricht, ein Zustellunternehmen zugeordnet ist, das Postsendungen zu diesem Zustellpunkt zustellt.

10. Logistiksystem nach einem der vorangegangenen Ansprüche,
**dadurch gekennzeichnet,**
**dass** der Transportweg der Postsendung in einer Datenbank festgelegt ist.

11. Logistiksystem nach Anspruch 10,
**dadurch gekennzeichnet,**
**dass** in der Datenbank eine Zuordnung zwischen den Knoten des Transportwegs und den eindeutigen Identifikationskennungen (RIO-ID) gespeichert ist.

12. Logistiksystem nach Anspruch 10 oder 11,
**dadurch gekennzeichnet,**
**dass** in der Datenbank eine Zuordnung zwischen den Knoten des Transportwegs und ihren Attributen gespeichert ist.

13. Logistiksystem nach einem der Ansprüche 10 bis 12,
**dadurch gekennzeichnet,**
**dass** in der Datenbank ein Zuordnung zwischen einem ersten Knoten und einem zweiten Knoten gespeichert ist, wobei der zweite Knoten dem ersten Knoten auf dem Transportweg der Postsendung vorausgeht oder nachfolgt.

14. Logistiksystem nach einem der vorangegangenen Ansprüche,
**dadurch gekennzeichnet,**
**dass** die Postsendung bei der Sortierung an einem Knoten, der einem Sortierpunkt entspricht, aufgrund eines Sortierplans an einen auf dem Transportweg der Postsendung nachfolgenden Knoten weitergeleitet wird.

15. Logistiksystem nach Anspruch 14,
**dadurch gekennzeichnet,**
**dass** der Sortierplan anhand der Festlegung von Transportwegen von Postsendungen innerhalb der Datenbank erzeugt wird.

16. Logistiksystem nach einem der vorangegangenen Ansprüche,
**dadurch gekennzeichnet,**
**dass** die eindeutige Identifikationskennung (RIO-ID) eines einem Zustellpunkt zugeordneten Knotens auf eine an den Zustellpunkt adressierte Postsendung aufbringbar ist und bei der Sortierung der Postsendung heranziehbar ist.

17. Logistiksystem nach Anspruch 16,
**dadurch gekennzeichnet,**
**dass** Knoten in dem Transportweg einer Postsendung enthalten sind, die an einen Zustellpunkt adressiert ist, der einem Knoten des Postverteilnetzes entspricht, deren Identifikationskennungen dem Knoten innerhalb des Sortierplans zugeordnet sind.

18. Logistiksystem nach einem der vorangegangenen Ansprüche,
**dadurch gekennzeichnet,**
**dass** den Knoten ein Sortiercode und/oder ein Sortiercodebereich zugeordnet ist.

19. Logistiksystem nach Anspruch 18,
**dadurch gekennzeichnet,**
**dass** einem Knoten, der einem Zustellpunkt entspricht, ein Sortiercode zugeordnet ist, welcher auf eine an den Zustellpunkt adressierte Postsendung aufbringbar und bei der Sortierung der Postsendung an einem Sortierpunkt heranziehbar ist.

20. Logistiksystem nach Anspruch 18 oder 19,
**dadurch gekennzeichnet,**
**dass** die Postsendung von einem ersten Knoten, der einem Sortierpunkt entspricht, an einen auf dem Transportweg nachfolgenden zweiten Knoten weitergeleitet wird, welchem innerhalb des Sortierplans der auf die Postsendung aufgebrachte Sortiercode und/oder ein Sortiercodebereich, der den auf die Postsendung aufgebrachten Sortiercode enthält, zugeordnet ist.

21. Verfahren zum Festlegen eines Transportwegs einer Postsendung innerhalb eines Postverteilnetzes, wobei der Transportweg mehrere Knoten des Postverteilnetzes enthält, insbesondere einen Knoten, der einem Zustellpunkt entspricht, sowie wenigstens einen Knoten, der einem Sortierpunkt entspricht,
**dadurch gekennzeichnet,**
**dass** den Knoten eine eindeutige Identifikationskennung zugeordnet ist und dass einem ersten Knoten die Identifikationskennung eines zweiten Knotens zugeordnet wird, wobei der zweite Knoten dem ersten Knoten auf dem Transportweg der Postsendung vorausgeht oder nachfolgt.

## Claims

1. A logistics system for transporting a mailpiece along a transportation route within a postal distribution network, the transportation route comprising several nodes of the postal distribution network, in particular a node that corresponds to a delivery point, as well as at least one node that corresponds to a sorting point,
**characterized in that**
an unambiguous identifier (RIO-ID) is associated with the nodes and **in that** the identifier (RIO-ID) of a second node is associated with a first node, the second node preceding or following the first node along the transportation route of the mailpiece.

2. The logistics system according to Claim 1,
**characterized in that**
the association of the identifier (RIO-ID) of the second node with the first node is variable.

3. The logistics system according to Claim 1 or 2,
**characterized in that**,
except for the first node (1) of the transportation route, each node contained in the transportation route of a mailpiece is associated with the identifier (RIO-ID) of the preceding node along the transportation route.

4. The logistics system according to Claim 1 or 2,
**characterized in that**,
except for the node that corresponds to the delivery point of the mailpiece, each node contained in the transportation route of a mailpiece is associated with the identifier (RIO-ID) of the node that follows along the transportation route.

5. The logistics system according to any of the preceding claims,
**characterized in that**
descriptive attributes are associated with the nodes.

6. The logistics system according to any of the preceding claims,
**characterized in that**
a node that corresponds to a delivery point is associated with at least one feature of a mailpiece addressed to the del ivery point.

7. The logistics system according to any of the preceding claims,
**characterized in that**
a node that corresponds to a delivery point is associated with a delivery address that is to be applied onto a mailpiece addressed to the delivery point.

8. The logistics system according to any of the preceding claims,
**characterized in that**
a node is associated with a delivery company that transports a mailpiece to the node.

9. The logistics system according to any of the preceding claims,
**characterized in that**
a node that corresponds to a delivery point is associated with a delivery company that delivers mailpieces to this delivery point.

10. The logistics system according to any of the preceding claims,
**characterized in that**
the transportation route of the mailpiece is stored in a database.

11. The logistics system according to Claim 10,
**characterized in that**
an association between the nodes of the transportation route and the unambiguous identifiers (RIO-ID) is stored in the database.

12. The logistics system according to Claim 10 or 11,
**characterized in that**
an association between the nodes of the transportation route and their attributes is stored in the database.

13. The logistics system according to any of the Claims 10 to 12,
**characterized in that**
an association between a first node and a second node is stored in the database, the second node preceding or following the first node along the transportation route of the mailpiece.

14. The logistics system according to any of the preceding claims,
**characterized in that**,
during the sorting at a node that corresponds to a sorting point, based on a sorting plan, the mailpiece is relayed to a node that follows along the transportation route of the mailpiece.

15. The logistics system according to Claim 14,
**characterized in that**
the sorting plan is generated within the database based on the specification of transportation routes of mailpieces.

16. The logistics system according to any of the preceding claims,
**characterised in that**
the unambiguous identifier (RIO-ID) of a node associated with a delivery point can be applied onto a mailpiece addressed to the delivery point and can be used during the sorting of the mailpiece,

17. The logistics system according to Claim 16,
**characterized in that**
nodes are contained in the transportation route of a mailpiece that is addressed to a delivery point that corresponds to a node of the postal distribution network, the identifiers of said nodes being associated with the node within the sorting plan.

18. The logistics system according to any of the preceding claims,
**characterized in that**
a sorting code and/or a sorting code range is associated with the nodes.

19. The logistics system according to Claim 18,
**characterised in that**
a node that corresponds to a delivery point is associated with a sorting code that can be applied onto a mailpiece addressed to the delivery point and that can he used during the sorting of the mailpiece at a sorting point.

20. The logistics system according to Claim 18 or 19,
**characterized in that**,
from a first node that corresponds to a sorting point, the mailpiece is relayed to a second node that follows along the transportation route, said second node being associated, within the sorting plan, with the sorting code applied onto the mailpiece and/or with a sorting code range that contains the sorting code applied onto the mailpiece.

21. A method for specifying a transportation route of a mailpiece within a postal distribution network, the transportation route comprising several nodes of the postal distribution network, in particular a node that corresponds to a delivery point and at least one node that corresponds to a sorting point,
**characterized in that**
an unambiguous identifier is associated with the nodes and **in that** the identifier of a second node is associated with a first node, the second node preceding or following the first node along the transportation route of the mailpiece.

## Revendications

1. Système logistique pour transporter un envoi postal sur un chemin de transport à l'intérieur d'un réseau de distribution postale, le chemin de transport comprenant plusieurs noeuds du réseau de distribution postale, en particulier un noeud qui correspond à un point de livraison et au moins un noeud qui correspond à un point de tri, **caractérisé en ce qu'**une identification univoque (RIO-ID) est associée aux noeuds et **en ce que** l'identification (RIO-ID) d'un deuxième noeud est associée à un premier noeud, le deuxième noeud précédant ou suivant le premier noeud sur le chemin de transport de l'envoi postal.

2. Système logistique selon la revendication 1, **caractérisé en ce que** l'association de l'identification (RIO-ID) du deuxième noeud au premier noeud est modifiable.

3. Système logistique selon la revendication 1 ou 2, **caractérisé en ce qu'**à chaque noeud contenu dans le chemin de transport d'un envoi postal, à l'exception du premier noeud du chemin de transport, est respectivement associée l'identification (RIO-ID) du noeud précédent sur le chemin de transport.

4. Système logistique selon la revendication 1 ou 2, **caractérisé en ce qu'**à chaque noeud contenu dans le chemin de transport d'un envoi postal, à l'exception du noeud qui correspond au point de livraison de l'envoi postal, est respectivement associée l'identification (RIO-ID) du noeud subséquent sur le chemin de transport.

5. Système logistique selon l'une des revendications précédentes, **caractérisé en ce que** des attributs descriptifs sont associés aux noeuds.

6. Système logistique selon l'une des revendications précédentes, **caractérisé en ce qu'**est associée à un noeud, qui est associé à un point de livraison, au moins une caractéristique d'envoi que présente un envoi postal adressé au point de livraison.

7. Système logistique selon l'une des revendications précédentes, **caractérisé en ce qu'**est associée, à un noeud qui correspond à un point de livraison, une adresse de livraison qui doit être apposée sur un envoi adressé au point de livraison.

8. Système logistique selon l'une des revendications précédentes, **caractérisé en ce qu'**est associée à un noeud une entreprise de livraison qui effectue le transport d'un envoi postal vers le noeud.

9. Système logistique selon l'une des revendications précédentes, **caractérisé en ce qu'**est associée, à un noeud qui correspond à un point de livraison, une entreprise de livraison qui délivre des envois postaux à ce point de livraison.

10. Système logistique selon l'une des revendications précédentes, **caractérisé en ce que** le chemin de transport de l'envoi postal est stocké dans une base de données.

11. Système logistique selon la revendication 10, **caractérisé en ce qu'**est stockée, dans la base de données, une association entre les noeuds du chemin de transport et les identifications univoques (RIO-ID).

12. Système logistique selon la revendication 10 ou 11, **caractérisé en ce qu'**est stockée, dans la base de données, une association entre les noeud du chemin de transport et leurs attributs.

13. Système logistique selon l'une des revendications 10 à 12, **caractérisé en ce qu'**est stockée, dans la base de données, une association entre un premier noeud et un deuxième noeud, le deuxième noeud précédant ou suivant le premier noeud sur le chemin de transport de l'envoi postal.

14. Système logistique selon l'une des revendications précédentes, **caractérisé en ce que** l'envoi postal, lors du tri à un noeud qui correspond au point de tri, est réacheminé, sur la base d'un plan de tri, vers un noeud subséquent sur le chemin de transport de l'envoi postal.

15. Système logistique selon la revendication 14, **caractérisé en ce que** le plan de tri est généré à l'aide de la détermination de chemins de transport d'envois postaux au sein de la base de données.

16. Système logistique selon l'une des revendications précédentes, **caractérisé en ce que** l'identification univoque (RIO-ID) d'un noeud associé à un point de livraison peut être apposée sur un envoi postal adressé au point de livraison et **en ce qu'**il peut y être fait appel lors du tri de l'envoi postal.

17. Système logistique selon la revendication 16, **caractérisé en ce que** sont contenus, dans le chemin de transport d'un envoi postal qui est adressé à un point de livraison qui correspond à un noeud du réseau de distribution postale, des noeuds dont les identifications sont associées au noeud au sein du plan de tri.

18. Système logistique selon l'une des revendications précédentes, **caractérisé en ce qu'**un code de tri et/ou une plage de codes de tri sont associés aux noeuds.

19. Système logistique selon la revendication 18, **caractérisé en ce qu'**est associé, à un noeud qui correspond au point de livraison, un code de tri qui peut être apposé sur un envoi postal adressé au point de livraison et auquel il peut être fait appel lors du tri de l'envoi postal à un point de tri.

20. Système logistique selon la revendication 18 ou 19, **caractérisé en ce que** l'envoi postal est réacheminé d'un premier noeud qui correspond à un point de tri vers un deuxième noeud subséquent sur le chemin de transport, auquel est associé, au sein du plan de tri, le code de tri apposé sur l'envoi postal et/ou une plage de codes de tri qui contient le code de tri apposé sur l'envoi postal.

21. Procédé pour déterminer un chemin de transport d'un envoi postal à l'intérieur d'un réseau de distribution postale, le chemin de transport comprenant plusieurs noeuds du réseau de distribution postale, en particulier un noeud qui correspond à un point de livraison et au moins un noeud qui correspond à un point de tri, **caractérisé en ce qu'**une identification univoque est associée aux noeuds et **en ce que** l'identification d'un deuxième noeud est associée à un premier noeud, le deuxième noeud précédant ou suivant le premier noeud sur le chemin de transport de l'envoi postal.
